# DEMANDE DE BREVET EUROPEEN

(11) **EP 4 524 288 A1**
(43) Date de publication de la demande: **19.03.2025**
(21) Numéro de dépôt: 23196903.1
(22) Date de dépôt: 12.09.2023
(51) Int. Cl.: C23C 18/12, C23C 14/00, C23C 28/00, C25D 5/02, C25D 7/00

(54) **PROCÉDÉ DE DÉCORATION D'UN SUBSTRAT PAR LE DÉPÔT D'UNE COUCHE DE MASQUAGE PAR VOIE SOL-GEL AFIN DE RÉALISER UNE PIÈCE D'HABILLAGE**

(60) Demande divisionnaire: 24179681.2
(71) Demandeur: Rubattel et Weyermann S.A., 2300 La Chaux-de-Fonds (CH)
(72) Inventeur: POLY, Giovanni, 25140 Charquemont (FR); JEANRENAUD, Frédéric, 2300 La Chaux-de-Fonds (CH)
(74) Mandataire: ICB SA

(57) **Abrégé**

L'invention concerne un procédé de décoration d'un substrat (11) pour réaliser une pièce d'habillage (10) comprenant les étapes successives de :
- dépôt d'une couche de masquage (12) dans un matériau électriquement isolant par voie sol-gel polymérique sur une surface d'habillage (110) d'un substrat (11) réalisé en matériau métallique ;
- ablation d'une partie de la couche de masquage (12) sur l'ensemble de son épaisseur de sorte à générer une cavité (13) dont la forme définie un motif prédéterminé ;
- dépôt d'une couche décorative (14) dans la cavité (13).

## Description

### Domaine technique de l'invention

L'invention relève du domaine des pièces d'horlogerie, de bijouterie ou d'articles de mode, et notamment de la fabrication de pièces d'habillage.

Plus particulièrement, l'invention concerne un procédé de décoration d'un substrat par le dépôt d'une couche de masquage par voie sol-gel afin de réaliser une pièce d'habillage. Ce procédé s'applique avantageusement à toute pièce d'habillage dans le domaine de l'horlogerie, de la bijouterie, des articles de mode tels que les articles de maroquinerie, de lunetterie, d'instruments d'écriture ou d'appareils portables électroniques.

### Arrière-plan technologique

Il existe de nombreux procédés pour la réalisation de revêtements décoratifs d'une surface d'une pièce d'habillage, telle qu'un cadran, une platine, un pont, un rouage, une masse oscillante, une lunette ou une carrure dans le domaine de l'horlogerie.

Ces décors sont notamment réalisés par une texturation et/ou par une mise en couleur d'un substrat.

La mise en couleur peut être réalisée par le dépôt d'une ou de plusieurs couches présentant une couleur intrinsèque ou interférentielle, suivant différentes méthodes, telles que le vernissage, les méthodes de dépôt par voie humide, par exemple la galvanoplastie, ou par voie sèche, par exemples les méthodes de dépôt sous vide, notamment par dépôt physique ou chimique en phase vapeur. Pour associer plusieurs couleurs sur une même pièce d'habillage, plusieurs couches colorées doivent être successivement être déposées, par exemple selon différentes méthodes de dépôt.

A cet effet, selon la méthode de dépôt il est nécessaire d'appliquer un masque sur une couche préalablement déposée ou sur le substrat à protéger, et d'ajourer éventuellement ce masque par ablation selon des motifs prédéterminés à colorer générant le décor. Ces masques sont généralement réalisés en résine, par exemple acrylique, polyuréthane ou nitrocellulosique, ou en résine photosensible lorsque le décor est réalisé par la mise en oeuvre d'un procédé de photolithographie.

Toutefois, ces résines peuvent devenir cassantes en vieillissant et peuvent ne pas supporter la mise sous courant nécessaire lors de la réalisation d'un dépôt par galvanoplastie, ce qui peut occasionner des infiltrations sous le masque lors du dépôt d'une couche colorée et donc des problèmes de respect des tolérances de génération du décor. Plus précisément, du fait de sa détérioration, l'adhésion du masque sur le substrat ou sur la couche qu'il est censé protéger peut devenir moins importante, voire le masque peut se désolidariser de la surface du substrat ou de la couche qu'il est censé protéger.

Il est à noter que le risque d'infiltration est d'autant plus élevé que le décor créé par ablation dans le masque est fin.

Des résines plus résistantes peuvent être utilisées afin d'éviter leur dégradation, mais les méthodes d'élimination du masque sont plus complexes.

Lorsque la mise en couleur est réalisée par dépôt physique ou chimique en phase vapeur, ce type de résine présente également des inconvénients. En effet, lors de la mise en oeuvre de ces méthodes de dépôt sous vide, la résine est à l'origine de phénomènes de dégazage, impliquant des temps de pompage plus important et une influence sur la répétabilité, l'homogénéité et les propriétés des revêtements réalisés. Les phénomènes de dégazage ont également pour effet d'atténuer les performances des pompes nécessaires à la mise en oeuvre des procédés de dépôt sous vide, voire d'endommager lesdites pompes.

Par ailleurs, la réalisation de l'ablation du masque génère une autre difficulté dans la mesure où elle engendre une élévation locale de température du masque dégradant la tenue de la résine.

### Résumé de l'invention

L'invention résout les inconvénients précités en proposant une solution de masquage présentant une excellente résistance mécanique et chimique, une absence de dégazage lors de dépôts sous vide et de très bonnes propriétés d'adhésion, tout en pouvant être retirée de façon sélective simplement et de manière répétable.

À cet effet, la présente invention concerne un procédé de décoration d'un substrat pour réaliser une pièce d'habillage comprenant les étapes successives de :
- dépôt d'une couche de masquage dans un matériau électriquement isolant par voie sol-gel polymérique sur une surface d'habillage d'un substrat, réalisée en matériau métallique ;
- ablation d'une partie de la couche de masquage sur l'ensemble de son épaisseur de sorte à générer une cavité dont la forme définie un motif prédéterminé ;
- dépôt d'une couche décorative dans la cavité.

Le substrat comporte un corps par exemple réalisé dans un matériau métallique et présentant dans ce cas la surface d'habillage. Alternativement, le corps du substrat peut être réalisé dans un matériau céramique, composite ou dans un matériau organique, auquel cas le substrat comporte une couche métallique recouvrant tout ou partie dudit corps, ladite couche métallique présentant alors la surface d'habillage.

Lors de l'étape d'ablation, grâce à la nature de la couche de masquage, l'éventuel échauffement de la couche de masquage n'est pas susceptible de la dégrader.

D'autre part, la tenue de la couche de masquage est préservée lors du dépôt de la couche décorative quelle que soit la technique de dépôt de cette dernière, de sorte à écarter tout risque d'infiltration. En effet, la couche de masquage étant déposée par voie sol-gel, elle présente une excellente adhésion du fait de sa nature. En outre, la couche de masquage étant électriquement isolante, elle n'est pas sensible au courant électrique généré lors d'un éventuel dépôt par galvanoplastie ou par pulvérisation cathodique de la couche décorative.

Un autre avantage de l'invention réside dans le fait que la couche de masquage présente de très bonnes propriétés d'adhésion, même sur des surfaces d'épargnes très faibles.

Dans des modes particuliers de mise en oeuvre, l'invention peut comporter en outre l'une ou plusieurs des caractéristiques suivantes, prises isolément ou selon toutes les combinaisons techniquement possibles.

Dans des modes particuliers de mise en oeuvre, la couche décorative est déposée par galvanoplastie, la couche de masquage et la couche décorative formant un décor.

Dans des modes particuliers de mise en oeuvre, la couche décorative est déposée par pulvérisation cathodique, le matériau constituant la couche de masquage est inorganique, et la couche de masquage et la couche décorative forment un décor. Le matériau de la couche de masquage étant inorganique, elle n'engendre aucun dégazage lors du dépôt de la couche décorative.

Dans des modes particuliers de mise en oeuvre, une couche de base est déposée sur le substrat, en particulier sur la surface d'habillage, avant le dépôt de la couche de masquage, l'étape d'ablation étant réalisée de sorte à éliminer une partie de la couche de base sur l'ensemble de son épaisseur selon le motif prédéterminé, la couche de masquage est retirée, après le dépôt de la couche décorative, lors d'une étape d'élimination, de sorte que la couche de base et la couche décorative forment un décor.

Dans des modes particuliers de mise en oeuvre, la couche de base est déposée par galvanoplastie et est réalisée en Ni, Au, Ag, Rh ou Cu. Dans ce cas, la couche de base présente une épaisseur comprise entre 0.5 et 15 µm.

Dans des modes particuliers de mise en oeuvre, la couche de base est déposée par méthode de dépôt physique en phase vapeur et est réalisée en Si ou Ti ou leurs oxydes respectifs, en Cr, Cu, Ag, Au, Al. Dans ce cas, la couche de base présente une épaisseur comprise entre 10 nm et 10 µm.

Dans des modes particuliers de mise en oeuvre, la couche de masquage présente une épaisseur comprise entre 0.5 et 10 µm.

Dans des modes particuliers de mise en oeuvre, la couche décorative est déposée par une méthode de dépôt physique ou chimique en phase vapeur, le matériau constituant la couche de masquage étant inorganique.

Dans des modes particuliers de mise en oeuvre, la couche décorative est déposée par galvanoplastie.

Dans des modes particuliers de mise en oeuvre, la couche décorative est réalisée en cuivre, en nickel, en or, en argent, en rhodium ou en ruthénium, et présente une épaisseur comprise entre 50 nm et 20 µm.

### Brève description des figures

D'autres caractéristiques et avantages de l'invention apparaîtront à la lecture de la description détaillée suivante donnée à titre d'exemple nullement limitatif, en référence aux dessins annexés dans lesquels :
- les figures 1 à 4 représentent schématiquement une vue de section d'étapes de réalisation d'un procédé de décoration d'un substrat pour la réalisation d'une pièce d'habillage, selon une première variante de mise en oeuvre ;
- les figures 5 à 9 représentent schématiquement une vue de section d'étapes de réalisation du procédé, selon une seconde variante de mise en oeuvre.

On note que les figures ne sont pas nécessairement dessinées à l'échelle pour des raisons de clarté.

### Description détaillée de l'invention

Dans une étape préliminaire, le procédé selon l'invention peut comprendre une opération de traitement de surface afin de modifier la rugosité d'une surface d'habillage 110 d'un substrat 11, ladite surface d'habillage 110 étant réalisée en matériau métallique, par exemple dans un alliage de cuivre, de fer, d'or, d'argent, etc. L'opération de traitement de surface peut consister en un sablage, un ponçage, un microbillage, un soleillage et/ou un usinage. La surface d'habillage 110 est destinée à être décorée par le procédé selon l'invention, comme décrit ci-après en détail.

Le substrat 11 présente un corps réalisé, soit dans un matériau métallique, auquel cas la surface d'habillage 110 est une surface du corps, soit dans un matériau céramique, composite ou un matériau organique, auquel cas la surface d'habillage 110 est une surface d'une couche métallique. Une telle couche métallique est, par exemple, réalisée en titane, chrome, cuivre, etc., et est déposée sur le corps, par exemple, par procédé de dépôt physique en phase vapeur.

Sur les figures, le substrat 11 est représenté avec un corps en matériau métallique, c'est-à-dire sans couche métallique.

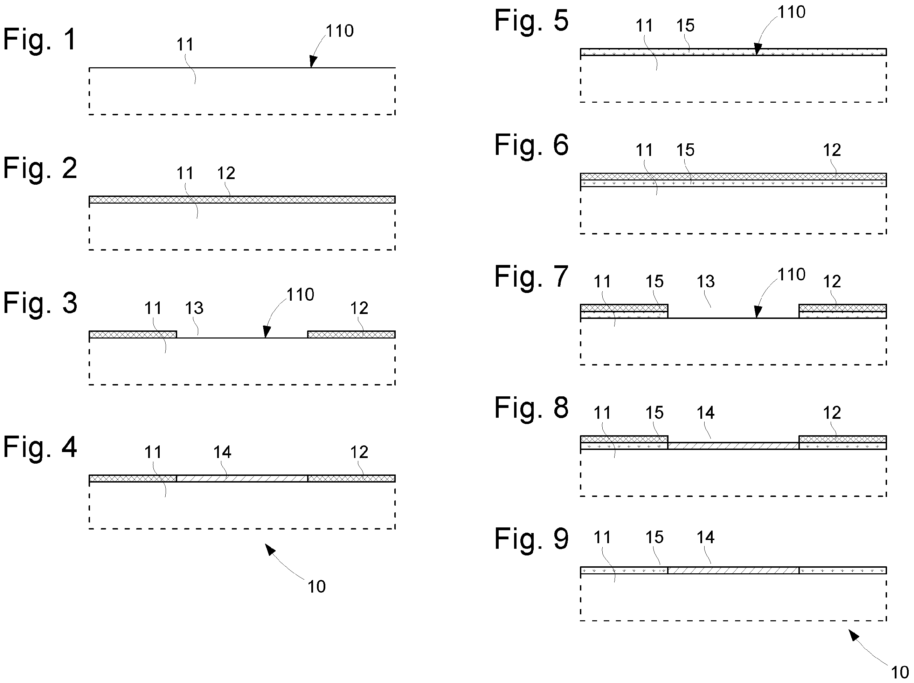

Dans une première variante de mise en oeuvre représentée sur les figures 1 à 4, le procédé comporte une étape de dépôt d'une couche de masquage 12 dans un matériau électriquement isolant par voie sol-gel polymérique directement sur la surface d'habillage 110. Cette étape de dépôt de la couche de masquage 12 est illustrée sur la figure 2.

En particulier, afin de réaliser cette étape, dans un premier temps une couche de matière est déposée, par exemple par pinceau, par immersion, par enduction lamellaire, par pulvérisation ou par centrifugation, puis elle est polymérisée dans une étuve chauffée par exemple à une température comprise entre 150 et 900 degrés Celsius, et plus particulièrement entre 200 et 250 degrés Celsius.

A titre d'exemple, la couche de masquage 12 présente une épaisseur comprise entre 0.5 et 10 µm, et peut être réalisée en oxyde de silicium, en oxyde de titane ou en oxyde d'aluminium.

Une partie de la couche de masquage 12 est ensuite éliminée lors d'une étape d'ablation représentée sur la figure 3, de sorte à former une ou des cavités 13 borgnes laissant apparaitre le substrat 11, et en particulier la couche métallique ou le corps du substrat 11. Autrement dit, une partie de la couche de masquage 12 est éliminée sur l'ensemble de son épaisseur. La forme des cavités 13 définie un motif prédéterminé représentatif d'un décor destiné à être coloré.

L'étape d'ablation est préférentiellement mise en oeuvre par usinage laser dans la mesure où il permet de réaliser très précisément des cavités 13 dont la largeur minimale peut aller jusqu'à de très faibles dimensions, typiquement de l'ordre du micromètre. Ainsi, les décors réalisés peuvent être très fins. Alternativement, l'étape d'ablation peut être mise en oeuvre par usinage mécanique ou par ablation chimique ou par toute autre méthode d'enlèvement de matière.

Telles que visibles sur la figure 4, les cavités 13 sont remplies par une couche décorative 14 lors d'une étape de dépôt mise en oeuvre par galvanoplastie ou par pulvérisation cathodique. A titre d'exemple, la couche décorative 14 peut être réalisée en cuivre, en nickel, en or, en argent, en rhodium ou en ruthénium, et peut présenter une épaisseur comprise entre 50 nm et 20 µm.

La couche de masquage 12 est avantageusement constituée par un matériau inorganique si la couche décorative 14 est déposé par pulvérisation cathodique, de sorte à éviter ou limiter fortement les phénomènes de dégazage.

Alternativement, le matériau constituant la couche de masquage 12 peut être organique ou inorganique si la couche décorative 14 est déposé par galvanoplastie.

Grâce aux caractéristiques de la couche de masquage 12, la couche décorative 14 n'adhère que sur le substrat 11. En effet, la couche de masquage 12 est électriquement isolante, elle n'est donc pas recouverte par la couche décorative 14 lors de son dépôt.

Dans cette première variante de mise en oeuvre de la présente invention, la couche de masquage 12 est conservée en tant que couche décorative, la couche de masquage 12 et la couche décorative 14 formant un décor. A cet effet, la couche de masquage 12 peut comporter un ou des colorants afin de présenter une couleur prédéterminée selon le décor souhaité.

Ainsi, la décoration du substrat 11 est réalisée par la couche de masquage 12 et par la couche décorative 14. Cette caractéristique est permise grâce à la nature de la couche de masquage 12 grâce à laquelle elle comporte une excellente résistance mécanique et chimique et donc présente une bonne tenue dans le temps.

Dans une seconde variante de mise en oeuvre représentée sur les figures 5 à 9, une couche de base 15 est déposée sur la surface d'habillage 110 avant le dépôt de la couche de masquage 12, tel qu'illustré en particulier sur la figure 5. Autrement dit, la couche de masquage 12 est déposée sur la couche de base 15, comme le montre la figure 6.

La couche de base 15 est déposée par galvanoplastie et est réalisée en nickel, en or, en argent, en rhodium ou en cuivre, et présente une épaisseur comprise entre 0,5 et 15 µm. Alternativement, la couche de base 15 peut être déposée par une méthode de dépôt sous vide, en particulier de dépôt physique en phase vapeur, et peut être réalisée en silicium ou en titane ou dans leurs oxydes respectifs, en chrome, en cuivre, en argent, en or ou en aluminium. Elle peut dans ce cas présenter une épaisseur comprise entre 10 nm et 10 µm.

De manière analogue à la première variante de mise en oeuvre, le procédé comporte une étape d'ablation de sorte à former des cavités 13 borgnes laissant apparaitre le substrat 11. En d'autres termes, une partie de la couche de base 15 et de la couche de masquage 12 est retirée sur l'ensemble de leur épaisseur, tel que visible sur la figure 7.

Par la suite, une couche décorative 14 est déposée et adhère uniquement sur le substrat 11 pour les mêmes raisons que décrites ci-dessus, comme le montre la figure 8.

A la différence de la première variante de mise en oeuvre du procédé, la couche de masquage 12 est retirée à la suite du dépôt de la couche décorative 14, lors d'une étape d'élimination réalisée de préférence par voie chimique ou électrochimique, de sorte que la couche de base 15 et la couche décorative 14 forment un décor. Par exemple, l'étape d'élimination est mise en oeuvre dans un bain alcalin chauffé, par exemple entre 40 et 60 degrés Celsius, et sous courant, par exemple entre 0.5 et 1.5 A/cm, selon les matériaux constituant la couche de masquage 12.

Avantageusement, la mise en oeuvre de l'étape d'élimination est relativement simple.

Dans cette seconde variante de mise en oeuvre de l'invention, la couche décorative 14 peut être déposée par toute méthode de dépôt physique ou chimique en phase vapeur, dans la mesure où si elle adhère sur la couche de masquage 12, suivant les affinités des matériaux constituant lesdites couches, sa partie adhérant à la couche de masquage 12 sera éliminée lors de l'étape d'élimination. La couche de masquage 12 est alors avantageusement constituée par un matériau inorganique, de sorte à éviter ou limiter fortement les phénomènes de dégazage lors du dépôt de la couche décorative 14.

La pièce d'habillage 10 représentée sur la figure 9 est alors obtenue.

Il est à noter que le caractère électriquement isolant de la couche de masquage 12 est également avantageux dans le cas d'un dépôt d'une couche d'accroche est nécessaire avant le dépôt de la couche décorative 14, par exemple en raison de la méthode de dépôt employée et des affinités des matériaux du substrat 11 et de la couche décorative 14. En effet, une telle couche d'accroche pourrait être déposée par galvanoplastie, et donc son dépôt serait réalisé de façon sélective uniquement sur le substrat 11.

De façon connue de l'homme du métier, la pièce d'habillage 10 peut être recouverte d'une couche de protection transparente, par exemple d'une résine acrylique, nitro-cellulosique, alkyde ou polyuréthane, déposée par pulvérisation.

De manière plus générale, il est à noter que les variantes de mise en oeuvre considérées ci-dessus ont été décrits à titre d'exemples non limitatifs, et que d'autres variantes sont par conséquent envisageables.

Notamment, dans chacune des variantes décrites, l'étape d'ablation peut être réalisée de sorte à générer une cavité débouchant sur la surface d'habillage 110 du substrat 11 ou de sorte à générer une cavité s'étendant en profondeur dans le substrat 11.

Il est également à noter que, dans le présent texte, pour des raisons de clarté et pour simplifier la lecture, le singulier est employé lorsqu'il est question de la couche de base 15 et de la couche décorative 14, toutefois ces couches peuvent être composées d'un empilement de couches.

## Revendications

1. Procédé de décoration d'un substrat (11) pour réaliser une pièce d'habillage (10) comprenant les étapes successives de :
- dépôt d'une couche de masquage (12) dans un matériau électriquement isolant par voie sol-gel polymérique sur une surface d'habillage (110) d'un substrat (11), réalisée en matériau métallique ;
- ablation d'une partie de la couche de masquage (12) sur l'ensemble de son épaisseur de sorte à générer une cavité (13) dont la forme définie un motif prédéterminé ;
- dépôt d'une couche décorative (14) dans la cavité (13).

2. Procédé selon la revendication 1, dans lequel la couche décorative (14) est déposée par galvanoplastie, la couche de masquage (12) et la couche décorative (14) formant un décor.

3. Procédé selon la revendication 1, dans lequel la couche décorative (14) est déposée par pulvérisation cathodique, le matériau constituant la couche de masquage (12) étant inorganique, et la couche de masquage (12) et la couche décorative (14) formant un décor.

4. Procédé selon la revendication 1, dans lequel une couche de base (15) est déposée sur le substrat (11) avant le dépôt de la couche de masquage (12), l'étape d'ablation étant réalisée de sorte à éliminer une partie de la couche de base (15) sur l'ensemble de son épaisseur selon le motif prédéterminé, la couche de masquage (12) est retirée, après le dépôt de la couche décorative (14), lors d'une étape d'élimination, de sorte que la couche de base (15) et la couche décorative (14) forment un décor.

5. Procédé selon la revendication 4, dans lequel la couche de base (15) est déposée par galvanoplastie et est réalisée en Ni, Au, Ag, Rh ou Cu.

6. Procédé selon la revendication 5, dans lequel la couche de base (15) présente une épaisseur comprise entre 0.5 et 15 µm.

7. Procédé selon la revendication 4, dans lequel la couche de base (15) est déposée par méthode de dépôt physique en phase vapeur et est réalisée en Si ou Ti ou leurs oxydes respectifs, en Cr, Cu, Ag, Au, Al.

8. Procédé selon la revendication 7, dans lequel la couche de base (15) présente une épaisseur comprise entre 10 nm et 10 µm.

9. Procédé selon l'une des revendications 4 à 8, dans lequel la couche de masquage (12) présente une épaisseur comprise entre 0.5 et 10 µm.

10. Procédé selon l'une des revendications 4 à 9, dans lequel la couche décorative (14) est déposée par une méthode de dépôt physique ou chimique en phase vapeur, le matériau constituant la couche de masquage (12) étant inorganique.

11. Procédé selon l'une des revendications 4 à 9, dans lequel la couche décorative (14) est déposée par galvanoplastie.

12. Procédé selon la revendication 1 à 11, dans lequel la couche décorative (14) est réalisée en cuivre, en nickel, en or, en argent, en rhodium ou en ruthénium, et présente une épaisseur comprise entre 50 nm et 20 µm.
